(19) Europäisches Patentamt
European Patent Office
Office européen des brevets

(11) **EP 4 539 269 A2**

(12) **EUROPÄISCHE PATENTANMELDUNG**

(43) Veröffentlichungstag:
**16.04.2025 Patentblatt 2025/16**

(21) Anmeldenummer: **24200136.0**

(22) Anmeldetag: **13.09.2024**

(51) Internationale Patentklassifikation (IPC):
**H01S 5/026** (2006.01)  **H01S 5/042** (2006.01)

(52) Gemeinsame Patentklassifikation (CPC):
**H01S 5/0261; H01S 5/0428**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **11.10.2023 DE 102023127718**

(71) Anmelder: **SICK AG**
**79183 Waldkirch (DE)**

(72) Erfinder: **Voigt, Rene**
**21629 Neu Wulmstorf (DE)**

(54) **ELEKTRONISCHE SCHALTUNG UND LASERSCANNER**

(57) Laserscanner (2) und elektronische Schaltung (1) zur Erzeugung von Laserpulsen für einen Laserscanner (2), mit einem Eingangskontakt (3) für eine Eingangsspannung, mit einer mit dem Eingangskontakt (3) verbundenen Reihenschaltung, bestehend aus mindestens einer Spule (L1) und mindestens einer ersten Diode (D1), wobei die erste Diode (D1) in Durchlassrichtung für die Eingangsspannung geschaltet ist, wobei mindestens ein mit der Reihenschaltung verbundenes Schaltelement (Q1) angeordnet ist, wobei mittels des Schaltelements (Q1) ein Schaltpfad gebildet ist, wobei an dem Gate des Schaltelements (Q1) ein Lasertriggersignal (12) anlegbar ist, wobei mit der Kathode der ersten Diode (D1) und dem Schaltelement (Q1) mindestens eine AntiParallelschaltung aus einer Laserdiode (LD) und einer zweiten Diode (D2) an einem Ende verbunden ist, wobei die Antiparallelschaltung von der Laserdiode (LD) und der zweiten Diode (D2) an dem anderen Ende mit mindestens einem ersten Kondensator (C1) verbunden ist, und der erste Kondensator (C1) mit dem anderen Ende mit Masse verbunden ist, wobei durch das Lasertriggersignal (12) an dem Schaltelement (Q1) ein optischer Laserpuls an der Laserdiode (LD) erzeugbar ist.

Fig.5

**Beschreibung**

Die vorliegende Erfindung betrifft eine elektronische Schaltung zur Erzeugung von Laserpulsen für einen Laserscanner nach dem Oberbegriff von Anspruch 1 und einen Laserscanner nach dem Oberbegriff von Anspruch 13.

Typischerweise bieten bestehende Lösungen entweder eine hochgradig fehlertolerante Schaltung in Bezug auf die Klassifizierung der Laserklasse 1, die Augensicherheit und unerwünschte Laseremission aufgrund eines Komponentenfehlers oder eine energieeffizientere Schaltung also einem Verhältnis einer Eingangsleistung von der Stromversorgung zur Stromversorgung der Laserdiode. Bei Laserdioden mit geringer Leistung ist in der Regel eine geringe Energieeffizienz akzeptabel. Bei neueren Sensoranwendungen mit hochmodernen Hochleistungslaserdioden kann eine geringe Energieeffizienz der Treiberschaltung den Gesamtstromverbrauch des Sensors um etwa 30-40 % erhöhen. Andererseits sind bekannte Lösungen für energieeffizientere Lasertreiberschaltungen deutlich anfälliger für Bauteilausfälle, die zu einer unerwünschten Laserlichtemission und damit am ehesten zu einer Verletzung der Grenzwerte der Laserklasse 1 führen. Um ein solches Szenario zu verhindern, ist ein erhöhter Bedarf an geeigneten Sicherheitserkennungsmechanismen erforderlich, was zu einer erhöhten Systemkomplexität und höheren Herstellungskosten führt.

Die Erfindung bietet eine Lösung für eine energieeffiziente und hochgradig fehlertolerante Lasertreiberschaltung, um diesen Design-Kompromiss zu überwinden.

Im Folgenden werden grundlegende Konzepte gängiger Lasertreiberschaltungen beschrieben:

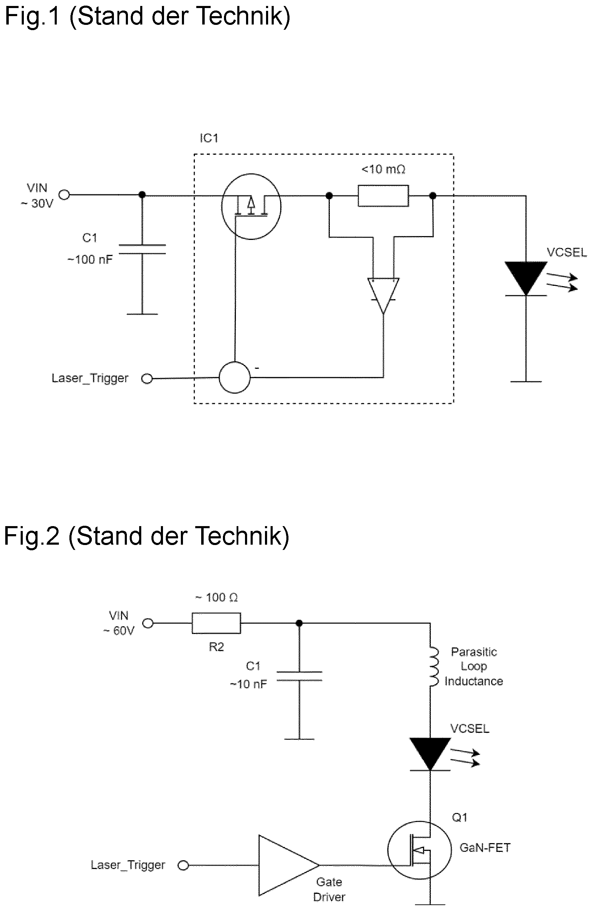

Figur 1 zeigt eine High-Side-Treiberlösung nach dem Stand der Technik. Bei diesem Konzept wird ein High-Side-Schaltelement verwendet, um einen Strom durch die Laserdiode zu leiten. Dabei kann es sich um eine integrierte oder eine diskrete Lösung handeln. Ein Kurzschluss des antreibenden Schaltelements führt direkt zu einer unerwünschten Laserlichtemission. Auch die Pulsbreite des Triggersignals wirkt sich direkt auf die Emissionszeit aus. Umfassende Detektionsmechanismen innerhalb des Treibers sind erforderlich, um die Laserklasse 1 zu gewährleisten.

Figur 2 zeigt einen resonanten kapazitiven Entladungslasertreiber nach dem Stand der Technik. Eine weit verbreitete und häufig verwendete Lasertreiberschaltung basiert auf einem resonanten Design, bestehend aus einer Kapazität, einer Laserdiode und einem Low-Side-Schaltelement. Meist werden Feldeffekttransistoren verwendet. Die Kapazität wird aufgeladen und speichert die Energie in der Regel für einen einzelnen Laserpuls. Um Laserlicht zu emittieren, wird das Schaltelement geschlossen und die Ladung des Kondensators durch die Laserdiode geleitet. Die Schleifeninduktivität der Stromschleife bildet mit der Kapazität einen Schwingkreis und definiert so die Impulsform.

Eine einfache und fehlertolerante Möglichkeit, die Kapazität aufzuladen, ist die Verwendung eines Widerstands zwischen Eingangsversorgung und Kapazität. Da die Kapazität bei jedem Schuss fast vollständig entladen wird, liegt der Wirkungsgrad beim Aufladen immer bei etwa 50 %. Dieses Konzept ist noch anfällig für einen Kurzschlussausfall des Schaltelements. Obwohl der Stromfluss durch den Widerstand begrenzt ist, ist aufgrund eines Bauteilausfalls dennoch eine unerwünschte Laserlichtemission möglich. In der Praxis kommen eine Vielzahl unterschiedlicher Konzepte zur Vorladung und der Anordnung dieser Komponenten zum Einsatz.

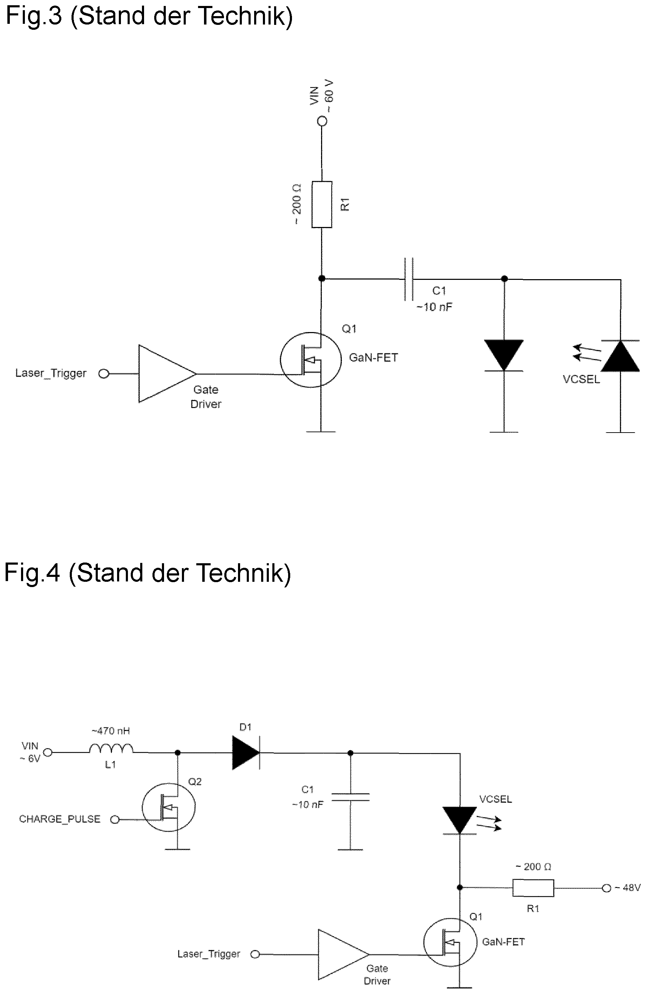

Figur 3 zeigt ein verbessertes Low-Side-Treiberdesign basierend auf einem Einzeltransistor-Avalanche-Pulse-Design nach dem Stand der Technik. Um eine unerwünschte Laserlichtemission im Falle eines Kurzschlusses des Schaltelements zu verhindern, wird die Kapazität auf der Kathodenseite der Laserdiode statt auf der Anodenseite vorgeladen.

Ein unüblicher Komponentenausfall innerhalb dieses Konzepts kann zu keiner unerwünschten Laseremission führen. Die einzige Möglichkeit, die Grenzwerte der Laserklasse 1 zu verletzen, ist eine falsche Eingangsversorgungsspannung und ein falsches Laser-Triggersignal, beispielsweise eine falsche Pulsbreite und/oder eine falsche Wiederholzeit. Die zusätzliche Diode in dieser Schaltung ist optional. Die Verwendung dieser Diode dient dazu, unerwünschte Klingeleffekte zu verhindern und hat keine allgemeine Funktion in Bezug auf Vorladung oder Laserlichtemission.

Figur 4 zeigt einen resonanten Lasertreiber mit High-Side-Boost-Schaltung nach dem Stand der Technik.

Ein weiteres Konzept ist die Verwendung einer Aufwärtswandler-Topologie als Ladeschaltung. Eine Induktivität, eine Diode und ein zusätzlicher Transistor kommen hinzu. Zum Vorladen wird der zusätzliche Transistor für eine definierte Zeit geschlossen. Die Zeit definiert die Spannung, auf die die Kapazität aufgeladen wird. Nach dem Öffnen des Transistors wird die in der Induktivität gespeicherte Energie innerhalb der Kapazität durch die hinzugefügte Diode verstärkt. An der Kathode der Laserdiode ist eine zusätzliche Spannung notwendig, um zu verhindern, dass in diesem Moment ein Strom durch die Laserdiode fließt, um die Drain-Source-Kapazität des Transistors aufzuladen. Die Eingangsspannung ist so ausgelegt, dass sie unter dem Schwellenwert liegt, um eine Laserlichtemission im Falle eines Kurzschlusses des Schaltelements zu verhindern. Dieses Konzept ist jedoch sehr anfällig für ein ungenaues Timing des Ladesignals und insbesondere für Bauteiltoleranzen. Es ist daher davon auszugehen, dass für die Anwendung der Laserklasse 1 schnell reagierende Sicherheitsdetektionsmechanismen erforderlich sind.

Eine Weiterbildung dieser Lösung stellt die Patentfamilie um das Patent US9368936 dar, welche ohne den genannten zusätzlichen Transistor auskommt und aufgrund der Topologie eine nahezu konstante Verdopplung der Eingangsspannung mit hoher Effizienz erzielt und dabei keine besondere Anfälligkeit gegenüber Timing und Bauteiltoleranzen aufweist. Nachteilig ist aber zu nennen, dass bei dieser Lösung ohne aufwendige zusätzliche Erkennungsmechanismen bereits ein einfacher Komponentenfehler des Schaltelements zu einer ungewollten Laseremission und zu einer Verletzung der Augensicherheit führen kann. Andere Konzepte sind auch in den Patenten US11075502B2, US11631961 B2 und US10673204B2 beschrieben, welche weitere mögliche Schaltungen und Lösungen für Treiberschaltungen für Laserdioden in einer gepulsten Laserlichtanwendung beschreiben.

In der Regel verwenden bestehende Lösungen ein hochgradig fehlertolerantes Konzept in Bezug auf Augensicherheit und unerwünschte Laseremission aufgrund eines Komponentenfehlers. In der Regel haben bestehende Lösungen auch eine geringe Energieeffizienz bezüglich der Eingangsleistung von der Stromversorgung zur elektrischen Stromversorgung der Laserdiode. Andere Lösungen verwenden Schaltkreise mit einer höheren Energieeffizienz, aber auch mit einer höheren Anfälligkeit für Komponentenausfälle, so dass ein erhöhter Bedarf an Sicherheitserkennungsmechanismen besteht. Zuvor wurden die einzelnen Nachteile der derzeit bekannten Lösungen erläutert. Darüber hinaus ist für die meisten Hochleistungsanwendungen eine hohe Eingangsversorgungsspannung, beispielsweise größer 60 Volt erforderlich, so dass zusätzliche Maßnahmen zur Erfüllung der elektrischen Sicherheitsstandards innerhalb des Gesamtsystems erforderlich sind.

US 2021/0333362 A1 offenbart ebenfalls eine Lichtemissionsvorrichtung. Die Lichtemissionsvorrichtung umfasst mindestens zwei Laseremissionsschaltungen, wobei jede der Laseremissionsschaltungen eine Stromversorgung, einen Laseremitter, eine Energiespeicherschaltung und eine Steuerschaltung umfasst; in jeder der Laseremissionsschaltungen ist die Steuerschaltung so konfiguriert, dass sie die Energiespeicherschaltung und die Stromversorgung in der Laseremissionsschaltung in einer ersten Zeitspanne einschaltet, damit die Stromversorgung Energie in der Energiespeicherschaltung speichern kann; die Steuerschaltung ist ferner so konfiguriert, dass sie den Laseremitter und die Energiespeicherschaltung in der Laseremissionsschaltung in einer zweiten Zeitspanne einschaltet, damit die Energiespeicherschaltung den Laseremitter mit Strom versorgt, damit der Laseremitter ein Lichtimpulssignal aussendet; und zwei oder mehr Laseremissionsschaltungen teilen sich die Stromversorgung.

Eine Aufgabe der Erfindung besteht darin, eine verbesserte, hochgradig fehlertolerante Treiberschaltung für Laserdioden in einer gepulsten Laserlichtanwendung mit einer Pulsbreite von wenigen Nanosekunden und hoher, gleichbleibender Pulsenergie bei hohen Spitzenströmen bereitzustellen.

Die Aufgabe wird gemäß Anspruch 1 gelöst durch eine elektronische Schaltung zur Erzeugung von Laserpulsen für einen Laserscanner, mit einem Eingangskontakt für eine Eingangsspannung, mit einer mit dem Eingangskontakt verbundenen Reihenschaltung, bestehend aus mindestens einer Spule und mindestens einer ersten Diode, wobei die erste Diode in Durchlassrichtung für die Eingangsspannung geschaltet ist, wobei mindestens ein mit der Reihenschaltung verbundenes Schaltelement angeordnet ist, wobei mittels des Schaltelements ein Schaltpfad gebildet ist, wobei an dem Gate des Schaltelements ein Lasertriggersignal anlegbar ist, wobei mit der Kathode der ersten Diode und dem Schaltelement mindestens eine Anti-Parallelschaltung aus einer Laserdiode und einer zweiten Diode an einem Ende verbunden ist, wobei die Antiparallelschaltung von der Laserdiode und der zweiten Diode an dem anderen Ende mit mindestens einem ersten Kondensator verbunden ist, und der erste Kondensator mit dem anderen Ende mit Masse verbunden ist, wobei durch das Lasertriggersignal an dem Schaltelement ein optischer Laserpuls an der Laserdiode erzeugbar ist.

Nach dem Start und dem Anlegen einer Spannung am Eingangskontakt wird der erste Kondensator über die Spule, die erste Diode und die zweite Diode mit einer Eingangsspannung am Eingangskontakt aufgeladen.

Der erste Kondensator ist ein einzelner Kondensator oder eine Reihe von Kondensatoren, um die für einen einzelnen Laserschuss erforderliche Energie zwischenzuspeichern.

Das Schaltelement ist beispielsweise ein Schaltelement mit einer sehr schnellen Schaltzeit, das in der Lage ist, einen hohen Spitzenstrom während des Laserpulses zu tragen und einer hohen Ladespannung standzuhalten. Das Schaltelement wird durch das externe Lasertriggersignal bzw. Steuersignal am Steuersignaleingang gesteuert. Ein Low-Side-Treiber ist vorzugsweise vorgesehen, um das Gate des verwendeten Schaltelements anzusteuern. Das Schaltelement leitet nur für eine extrem begrenzte Zeit, wenn das externe Lasertriggersignal aktiviert wird.

Während des ersten Pulses von Lasertriggersignal, beginnend bei einem ersten Zeitpunkt, wird der erste Kondensator vollständig durch die Laserdiode und das Schaltelement entladen und ein erster niedrigerer Laserpuls erzeugt. In diesem Moment ist der Spannungspegel der Laserdiodenkathode (entspricht dem Drainanschluss des Schaltelements) der gleiche wie die Massereferenz, was zu einem Spannungsabfall vom ersten Kondensator auf das Schaltelement gleich der Eingangsspannung führt. Ein Strom durch die Spule und der ersten Diode beginnt zu fließen.

Nachdem das Schaltelement geschlossen wurde, steigt der Strom durch die Spule und die erste Diode weiter an und lädt den ersten Kondensator bis zur Spannung der zweiten Diode, bis der Spannungspegel an der Laserdiodenkathode bei einem zweiten Zeitpunkt die Höhe der Eingangsspannung erreicht und nun auf dem gleichen Spannungsniveau wie die Eingangsspannung liegt. Von nun an nimmt der Strom durch die Spule ab, bis dieser bei einem dritten Zeitpunkt wieder 0 Ampere erreicht. Währenddessen wird der erste Kondensator immer noch auf ein Spannungsniveau geladen, das fast dem zweifachen der Eingangsspannung entspricht.

Nach dem dritten Zeitpunkt wird ein negativer Strom durch die Spule durch die erste Diode verhindert, so dass der erste Kondensator nicht durch die Laserdiode und die Spule entladen wird. Unter realen Bedingungen bleibt nur eine leichte Schwingung zurück, die aber nicht zu einer unerwünschten Beleuchtung der Laserdiode führt. Der erste Kondensator speichert die Energie für den nächsten Laserpuls mit einer Ladespannung von fast zweimal der Eingangsspannung, bis das Lasertriggersignal die Schaltung bei einem vierten Zeitpunkt wieder auslöst.

Einen grundsätzlichen Unterschied, insbesondere im Vergleich zu der Patentanmeldung US 2021/0333362 A1 gibt es in der Idee, wie das Schaltelement gemäß der Erfindung eingesetzt wird. Bei einem resonanten Lasertreiber mit High-Side-Boost-Schaltung und normalen Aufwärtswandlerschaltungen ist das Schaltelement so lange wie nötig geschlossen, um den Strom durch die Induktivität zu erhöhen, und das Schaltelement, um das Magnetfeld innerhalb der Induktivität auf einen bestimmten Wert zu erhöhen, um eine Ladespannung zu erreichen, die ein Vielfaches der Eingangsspannung ist. Durch Änderung der Zeit, in der das Schaltelement geschlossen ist, kann die gespeicherte Ladung am ersten Kondensator bzw. die Ladespannung gesteuert werden.

Das Schaltelement wird in dieser Erfindung aber nur für eine begrenzte Zeit, insbesondere eine extrem begrenzte Zeit, nämlich wenige Nanosekunden geschlossen, um den Laserlichtpuls freizusetzen. Während dieser Zeit kann sich kein nennenswerter Strom durch die Induktivität und das Schaltelement aufbauen. Aber die sehr kurze Zeit, in der das Schaltelement geschlossen ist, reicht aus, dass der Spannungspegel der Laserdiodenkathode nahe 0 Volt beträgt und der zuvor beschriebene Ladestrom in Gang gesetzt wird. Solange das Schaltelement nicht viel länger geschlossen ist, beträgt die Spannung an dem ersten Kondensator nach dem Laden fast das Doppelte der Eingangsspannung, unabhängig davon, wann das Schaltelement geschlossen war. Das bedeutet zum einen, dass mit der Schließzeit des Schaltelements die Möglichkeit verloren geht, die Ladespannung direkt zu steuern. Andererseits ist es nicht möglich, eine Spannung zu erzeugen, die höher als das Doppelte der Eingangsspannung ist, und somit ist die maximale Energie pro Impuls absolut vorhersagbar. Es ist kein zusätzlicher Sicherheitsmechanismus, z. B. Hochgeschwindigkeits-Spannungsmessung erforderlich. Und die Energie pro Impuls kann immer noch durch Änderung der Eingangsversorgungsspannung gesteuert werden, die mit einer relativ langsamen Spannungsmessung gemessen werden kann.

Um die Anfälligkeit gegenüber einer falschen Pulsbreite des Lasertriggersignals weiter zu verbessern, kann die Spule bzw. Induktivität verwendet werden, bei der der Spitzenladestrom durch die Spule nahe am Sättigungsstrom des Induktortyps liegt. Selbst wenn die Pulsbreite des Lasertriggersignals zu groß ist, ist die Spule bzw. Induktivität nicht in der Lage, mehr magnetische Energie zu speichern und so eine Überladung des ersten Kondensators zu verhindern. Außerdem steigt der Strom durch die Spule schnell an und ein einfach zu implementierender Leistungsschalter kann eine solche Fehlersituation erkennen.

Bei der Laserdiode handelt es sich beispielsweise um eine 5J VCSEL Laserdiode oder einen mehrkanaligen Kantenemitter.

Die wichtigsten Vorteile dieser Erfindung sind:

Ein hoher Ladewirkungsgrad von bis zu 97 % im Vergleich zur üblicherweise verwendeten RC-Ladeschaltung mit 50 %. Der Gesamtwirkungsgrad, nämlich die elektrische Eingangsleistung zu optischer Ausgangsleistung, hängt vom genannten Ladewirkungsgrad, dem Leistungsumwandlungswirkungsgrad der Laserdiode sowie dem Entladewirkungsgrad, hauptsächlich definiert durch die Verluste innerhalb des verwendeten Schaltelements, ab.

Es erfolgt keine schädliche Laseremission bei typischen Bauteilausfällen, z.B. Kurzschluss des Schaltelements, und somit sind keine Sicherheitserkennungsmechanismen innerhalb der Lasertreiberschaltung erforderlich. Die Integrität der eingehenden Spannungsversorgung und des Lasertriggersignals muss an den entsprechenden Modulen sichergestellt werden, wo sie erzeugt werden. Eine gefährliche Laserlichtemission kann lediglich auftreten, wenn ein Eingangssignal nicht korrekt ist, also eine falsche Versorgungsspannung oder falsches Lasertriggersignal vorliegt.

Es liegt ein robustes System gegen unzureichende Genauigkeit der Pulsbreite des Lasertriggersignals vor.

Es liegt keine unkritische Mindestpulsbreite und kein unkritisches Abschaltverhalten des Schaltelements vor.

Es wird nur eine relativ niedrige Eingangsspannung im Vergleich zur erforderlichen Spitzenspannung für die Erzeugung von Laserschüssen benötigt. Die Hochspannung ist auf die Laserantriebsschaltung beschränkt, so dass die Anforderungen der elektrischen Sicherheitsnormen leichter zu erfüllen sind.

Es werden stabile, wiederholbare Pulsformen mit gleichbleibender Pulsenergie erzeugt.

In Weiterbildung der Erfindung ist mindestens einer mit dem Eingangskontakt verbundener parallel geschalteter zweiter Kondensator angeordnet.

Der zweite Kondensator ist ein Kondensator oder sind beispielsweise mehrere Bulk-Kondensatoren mit einer viel größeren Kapazität als der erste Kondensator, um eine ausreichende Stabilisierung der Eingangsspannung am Eingangskontakt zu ermöglichen.

In Weiterbildung der Erfindung ist das Schaltelement insbesondere ein Schalttransistor, insbesondere ein Feldeffekttransistor, ganz insbesondere ein Galliumnitrid-Feldeffekttransistor.

Im Gegensatz zu den stromgesteuerten Bipolartransistoren sind Feldeffekttransistoren spannungsgesteuerte Schaltungselemente. Die Steuerung erfolgt über die Gate-Source-Spannung, welche zur Regulation des Kanalquerschnittes bzw. der Ladungsträgerdichte dient, d. h. des Halbleiter-Widerstands, um so die Stärke eines elektrischen Stromes zu schalten oder zu steuern.

Feldeffekttransistor eignen sich besonders für das Schalten von hohen Strömen. Galliumnitrid-Feldeffekttransistoren eignen sich ganz besonders für das Schalten von hohen Strömen.

In Weiterbildung der Erfindung ist das Lasertriggersignal durch einen Low-Side-FET-Treiber erzeugt. Der Low-Side-FET-Treiber ist eine integrierte elektronische Schaltung, welche den Leistungsschalter also das Schaltelement ansteuert.

Ein Transistor-Treiber bzw. der Low-Side-FET-Treiber ist eine Schaltung, welche die nötige Spannung zur Verfügung stellt, um einen Transistor in der erforderlichen Zeit ein- bzw. auszuschalten. Es handelt sich dabei meist um einen Verstärker mit zusätzlichem Pegelwandler. Dadurch ist es möglich, mit einem Logikausgang, welcher meist mit 5 oder 3,3V betrieben wird, große Lasten wie Feldeffekttransistoren zu schalten. Dieser Treiber kann analog oder digital arbeiten.

Während des ersten Pulses von Lasertriggersignal, beginnend bei einem ersten Zeitpunkt, wird der erste Kondensator vollständig durch die Laserdiode und das Schaltelement entladen und ein erster niedrigerer Laserpuls erzeugt. In diesem Moment ist der Spannungspegel der Laserdiodenkathode der gleiche wie die Massereferenz, was zu einem Spannungsabfall vom zweiten Kondensator auf das Schaltelement gleich der Eingangsspannung führt. Wird die Pulsbreite des Lasertriggersignals länger gewählt, als die berechnete Laserpulsbreite wird eine vollständige Entladung des ersten Kondensators gewährleistet.

In Weiterbildung der Erfindung ist die Kapazität des zweiten Kondensators mindestens 500 mal größer und insbesondere 1000 mal größer, als die Kapazität des ersten Kondensators, um eine ausreichende Stabilisierung der Eingangsspannung am Eingangskontakt zu ermöglichen.

In Weiterbildung der Erfindung wird das Schaltelement durch das Lasertriggersignal nur 5 bis 50 Nanosekunden, insbesondere 15 bis 20 Nanosekunden geschlossen, um einen Laserimpuls an der Laserdiode freizusetzen.

Die Weiterbildung betrifft eine Treiberschaltung für Laserdioden in einer gepulsten Laserlichtanwendung mit einer Pulsbreite von wenigen Nanosekunden insbesondere 5 bis 30 ns und hoher Pulsenergie, beispielsweise wenige pJ pro Laserschuss mit hohen Spitzenströmen. Beispielsweis größer 100 Ampere werden verwendet.

Das Schaltelement wird nur für eine extrem begrenzte Zeit, nämlich wenige Nanosekunden geschlossen, um den Laserlichtpuls freizusetzen. Während dieser Zeit kann sich kein nennenswerter Strom durch die Induktivität und das Schaltelement aufbauen. Aber die sehr kurze Zeit, in der das Schaltelement geschlossen ist, reicht aus, dass der Spannungspegel der Laserdiodenkathode nahe 0 V beträgt und der zuvor beschriebene Ladestrom in Gang gesetzt wird. Solange das Schaltelement nicht viel länger geschlossen ist, beträgt die Spannung an der Kapazität nach dem Laden fast das Doppelte der Eingangsspannung, unabhängig davon, wann das Schaltelement geschlossen war. Das bedeutet zum einen, dass mit der Schließzeit des Schaltelements die Möglichkeit verloren geht, die Ladespannung direkt zu steuern. Andererseits ist es nicht möglich, eine Spannung zu erzeugen, die höher als das Doppelte der Eingangsspannung ist, und somit ist die maximale Energie pro Impuls absolut vorhersagbar. Es ist kein zusätzlicher Sicherheitsmechanismus, z. B. Hochgeschwindigkeits-Spannungsmessung erforderlich. Und die Energie pro Impuls kann immer noch durch Änderung der Eingangsversorgungsspannung gesteuert werden, die mit einer relativ langsamen Spannungsmessung gemessen werden kann.

In Weiterbildung der Erfindung wird die Energie pro Laserpuls durch eine Steuerung der Eingangsversorgungsspannung eingestellt.

Mittels der verwendeten Eingangsversorgungsspannung kann somit die Energie pro Laserpuls einfach eingestellt bzw. gesteuert oder geregelt werden.

In Weiterbildung der Erfindung wird die Energie pro Laserpuls nicht durch eine Veränderung der Pulsbreite des Lasertriggersignals eingestellt.

In Weiterbildung der Erfindung bilden der erste Kondensator, die Laserdiode und das Schaltelement einen resonanten Entladungslasertreiber.

Diese Weiterbildung nutzt das Prinzip des resonanten kapazitiven Entladungslasertreibers und besteht aus einer Kapazität, einer Laserdiode und einem Schaltelement. Im Gegensatz zur herkömmlichen Lösung wird die Ladeschaltung jedoch mit der Kathodenseite des Lasertreibers verbunden, während die Kapazität noch mit der Anode verbunden ist. Um einen Stromfluss zum Aufladen zu ermöglichen, wird eine antiparallele Diode hinzugefügt. Mit dieser Änderung wird der kritischste Ausfall eines kurzgeschlossenen Schaltelements überwunden.

In Weiterbildung der Erfindung bildet die Spule, die erste Diode und das Schaltelement eine Aufwärtswandlerschaltung, wobei das Schaltelement nur für eine begrenzte Zeit geschlossen ist, sodass schaltungsbedingt eine nur in Abhängigkeit der Eingangsspannung und damit deterministische Spannung erzeugt wird, welche nahezu der zweifachen Eingangsspannung entspricht.

Um den vergleichbar niedrigen Wirkungsgrad von 50 % mit einem üblicherweise verwendeten Ladewiderstand zu überwinden, wird eine Schaltung mit einer gemeinsamen Aufwärtswandlertopologie, bestehend aus einer Induktivität, einer Diode und einem Transistor, verwendet. Es wird das Hochgeschwindigkeitsschaltelement des Schwingantriebskreises verwendet, wobei dieses nur für eine begrenzte Zeit, insbesondere eine extrem begrenzte Zeit geschlossen ist, sodass schaltungsbedingt eine nur in Abhängigkeit der Eingangsspannung und damit deterministische Spannung erzeugt wird, welche nahezu der zweifachen Eingangsspannung entspricht.

Gemäß der Weiterbildung wird das Schaltelement durch das Lasertriggersignal beispielsweise nur 5 bis 50 Nanosekunden, insbesondere 15 bis 20 Nanosekunden geschlossen, um einen Laserimpuls an der Laserdiode freizusetzen.

In Weiterbildung der Erfindung sind der Antiparallelschaltung von der Laserdiode und der zweiten Diode weitere Antiparallelschaltungen von Laserdioden und Dioden parallel geschaltet, wobei diese Antiparallelschaltungen jeweils mit mindestens einem weiteren Kondensator verbunden sind, und diese mit dem anderen Ende mit Masse verbunden ist, wobei durch das Lasertriggersignal an dem Schaltelement ein optischer Laserpuls zeitgleich an allen Laserdioden erzeugbar ist.

In Weiterbildung der Erfindung sind die Laserdioden in einem gemeinsamen Gehäuse oder auf einem gemeinsamen Substrat angeordnet.

Die Aufgabe wird weiter gemäß Anspruch 13 gelöst mit einem Laserscanner mit einer elektronischen Schaltung gemäß Anspruch 1. Ein Laserscanner weist mindestens ein Sendeelement und mindestens ein Empfangselement und eine Steuer- und Auswerteeinheit zur Auswertung der Lichtlaufzeit von Lichtstrahlen vom Sendeelement über ein Objekt zum Empfangselement auf. Das Sendeelement weist die Laserdiode auf.

In Weiterbildung der Erfindung weist der Laserscanner mindestens ein Sendeelement und mindestens ein Empfangselement und eine Steuer- und Auswerteeinheit zur Auswertung der Lichtlaufzeit von Lichtstrahlen vom Sendeelement über ein Objekt zum Empfangselement auf. Dabei sind eine Vielzahl von Sendeelementen und eine Vielzahl von Empfangselementen in einem gemeinsamen Gehäuse angeordnet, wobei die Lichtstrahlen in verschiedenen Winkelrichtungen fächerförmig ausgesendet und/oder empfangen werden, wobei sich die Abstände der ausgesendeten Lichtstrahlen der Sendeelemente mit größer werdendem Abstand zum Laserscanner vergrößern und/oder die Abstände der empfangenen Lichtstrahlen der Empfangselemente mit kleiner werdendem Abstand zum Laserscanner verkleinern. Die Sendeelemente und Empfangselemente sind beispielsweise in einer Reihe angeordnet. Eine Winkelablenkung kann über eine Optik erfolgen.

Eine bevorzugte Anwendung ist der Einsatz der elektronischen Schaltung in einem Solid-State-Flash-Li-

DAR-Sensor der Laserklasse 1.

Gemäß der Weiterbildung werden die Lichtstrahlen in verschiedenen Winkelrichtungen fächerförmig ausgesendet bzw. empfangen, wodurch ein Überwachungsbereich dahingehend einfach untersucht werden kann, ob Objekte in dem Überwachungsbereich vorhanden sind oder nicht und an welcher Stelle, d. h. in welcher Entfernung die Objekte vorhanden sind. Weiter können die Objekte vermessen werden, bzw. eine Umgebungskontur und deren Veränderung erfasst werden. Durch die fächerförmige Aussendung der Lichtstrahlen, bzw. das fächerförmige Empfangen wird der Überwachungsbereich innerhalb einer fächerförmigen Ebene überwacht. Der Laserscanner kann mit einer hohen Winkelgenauigkeit hergestellt werden, da die Sendeelemente und Empfangselemente fest fixiert sind und die Lichtstrahlen direkt, ohne bewegliche Teile in den Überwachungsbereich gelangen. Dadurch ist gewährleistet, dass jeder Laserscanner eine bestimmte geforderte mindeste Winkelgenauigkeit einhält.

Der Laserscanner ist daher einfach und preiswert aufgebaut. Da der Laserscanner ohne mechanisch bewegliche Teile auskommt, weist dieser keinen mechanischen Verschleiß auf und besitzt eine lange Lebensdauer. Beispielsweise kann eine geforderte Einsatzdauer von beispielsweise ca. 20 Jahren mit dem erfindungsgemäßen Laserscanner erfüllt werden.

Da der Laserscanner ohne bewegliche Teile auskommt, die beispielsweise beim Einsatz in Fahrzeugen Beschleunigungen ausgesetzt sein können, ist der erfindungsgemäße Laserscanner unempfindlicher gegen Schwing- und Schockbelastungen und kann daher problemlos in mechanisch bewegten Objekten wie Fahrzeugen insbesondere Flurförderfahrzeugen eingesetzt werden. Dadurch, dass der Laserscanner ohne bewegliche Teile auskommt, kann der Laserscanner auch sehr kompakt ausgeführt werden.

In Weiterbildung der Erfindung weist der Laserscanner mindestens ein Sendeelement und mindestens ein Empfangselement und eine Steuer- und Auswerteeinheit zur Auswertung der Lichtlaufzeit von Lichtstrahlen vom Sendeelement über ein Objekt zum Empfangselement auf. Dabei ist eine Umlenkeinheit vorgesehen zur Ablenkung der Sendelichtstrahlen des Sendelements und/oder zur Ablenkung der Empfangslichtstrahlen für das Empfangselement. Bei dem Umlenkelement kann es sich beispielsweise um einen Drehspiegel oder einen Schwingspiegel handeln.

Durch die Umlenkeinheit braucht nur ein einziges Sendeelement und/oder ein einziges Empfangselement vorgesehen zu werden.

In Weiterbildung der Erfindung ist der Laserscanner ein Mehrebenenlaserscanner, wobei der Mehrebenenlaserscanner ausgebildet ist mehrere Abtastebenen zu bilden. Beispielsweise können die mehreren Abtastebenen fächerförmige angeordnet sein. Es kann aber auch vorgesehen sein mehrere parallele Abtastebenen zu bilden.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:

Figur 1     eine High-Side-Treiberlösung nach dem Stand der Technik;

Figur 2     einen resonanten kapazitiven Entladungslasertreiber nach dem Stand der Technik;

Figur 3     ein verbessertes Low-Side-Treiberdesign basierend auf einem Einzeltransistor-Avalanche-Pulse-Design nach dem Stand der Technik;

Figur 4     einen resonanten Lasertreiber mit High-Side-Boost-Schaltung nach dem Stand der Technik;

Figur 5     eine elektronische Schaltung zur Erzeugung von Laserpulsen für einen Laserscanner;

Figur 5a    eine elektronische Schaltung zur Erzeugung von Laserpulsen für einen Laserscanner;

Figur 6     eine elektronische Schaltung zur Erzeugung von Laserpulsen für einen Laserscanner;

Figur 6a    eine elektronische Schaltung zur Erzeugung von Laserpulsen für einen Laserscanner;

Figur 6b    eine elektronische Schaltung zur Erzeugung von Laserpulsen für einen Laserscanner;

Figur 7     ein Diagramm der auftretenden Signale und Spannungen und Ströme;

Figur 8     einen Laserscanner.

In den nachfolgenden Figuren sind identische Teile mit identischen Bezugszeichen versehen.

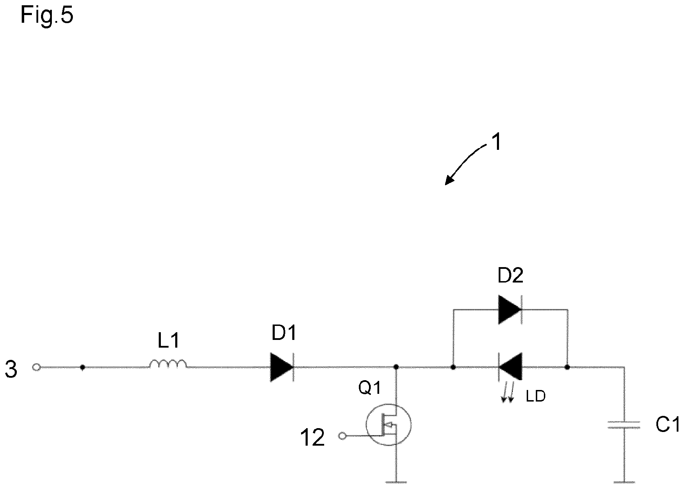

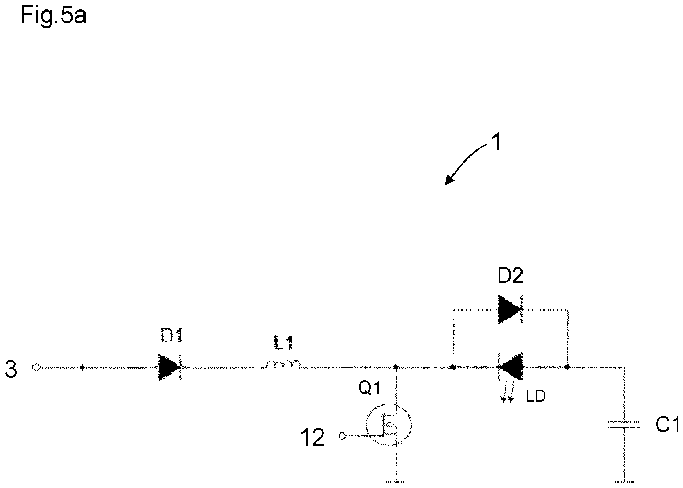

Figur 5 zeigt eine elektronische Schaltung 1 zur Erzeugung von Laserpulsen für einen Laserscanner, mit einem Eingangskontakt 3 für eine Eingangsspannung, mit einer mit dem Eingangskontakt verbundenen Reihenschaltung, bestehend aus mindestens einer Spule L1 und mindestens einer ersten Diode D1, wobei die erste Diode D1 in Durchlassrichtung für die Eingangsspannung geschaltet ist, wobei mindestens ein mit der Reihenschaltung verbundenes Schaltelement Q1 angeordnet ist, wobei mittels des Schaltelements Q1 ein Schaltpfad gebildet ist, wobei an dem Gate des Schaltelements Q1 ein Lasertriggersignal 12 anlegbar ist, wobei mit der Kathode der ersten Diode D1 und dem Schaltelement Q1 mindestens eine Anti-Parallelschaltung aus einer Laserdiode LD und einer zweiten Diode D2 an einem Ende verbunden ist, wobei die Antiparallelschaltung von der Laserdiode LD und der zweiten Diode D2 an dem anderen Ende mit mindestens einem ersten Kondensator C1 verbunden ist, und der erste Kondensator C1 mit dem anderen Ende mit Masse verbunden ist, wobei durch das Lasertriggersignal 12 an dem Schaltelement Q1 ein optischer Laserpuls an der Laserdiode LD erzeugbar ist.

Figur 5 zeigt die elektronische Schaltung 1 mit dem Eingangskontakt 3 für die Eingangsspannung, mit mindestens der mit dem Eingangskontakt verbundenen Spule L1, mit mindestens der mit der Spule L1 in Reihe geschalteten ersten Diode D1, wobei die erste Diode D1 in Durchlassrichtung für die Eingangsspannung geschaltet ist, wobei mindestens das mit der Kathode der ersten Diode D1 verbundene Schaltelement Q1 angeordnet ist.

Jedoch kann gemäß Figur 5a mit dem Eingangskontakt auch die Diode D1 verbunden sein und mit der Diode D1 die Spule L1 in Reihe geschaltet sein, so dass die Spule L1 und die Diode D1 eine Reihenschaltung bilden.

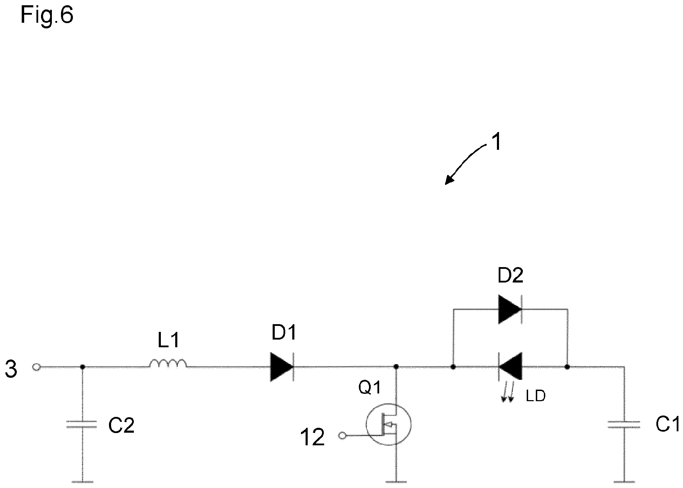

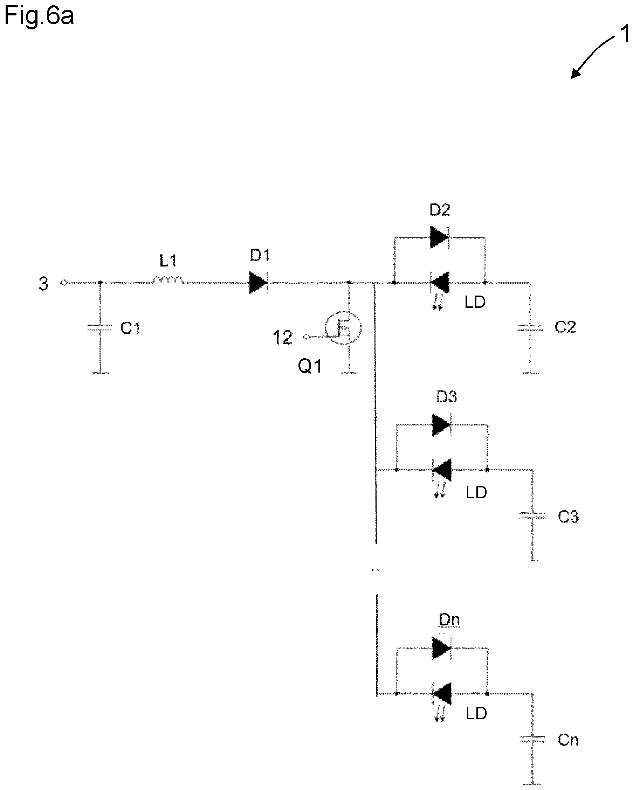

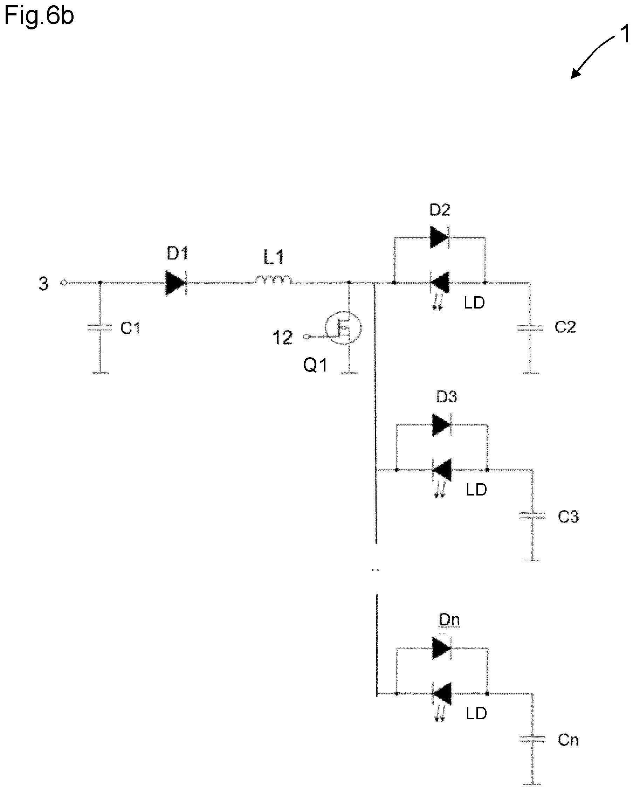

Beispielsweise ist gemäß Figur 6 mindestens ein mit dem Eingangskontakt 3 verbundener parallel geschalteter zweiter Kondensator C2 angeordnet.

Nach dem Start und dem Anlegen einer Spannung am Eingangskontakt 3 werden der zweite Kondensator C2 und der erste Kondensator C1 über die Spule L1, die erste Diode D1 und die zweite Diode D2 mit einer Eingangsspannung am Eingangskontakt 3 aufgeladen. Der erste Kondensator C1 ist ein einzelner Kondensator oder eine Reihe von Kondensatoren, um die für einen einzelnen Laserschuss erforderliche Energie zwischenzuspeichern. Der zweite Kondensator C2 ist ein Kondensator oder sind beispielsweise mehrere Bulk-Kondensatoren mit einer viel größeren Kapazität als der erste Kondensator C1.

Das Schaltelement Q1 ist beispielsweise ein Schaltelement Q1 mit einer sehr schnellen Schaltzeit, das in der Lage ist, einen hohen Spitzenstrom während des Laserpulses zu tragen und einer hohen Ladespannung standzuhalten. Das Schaltelement Q1 wird durch das externe Lasertriggersignal 12 bzw. Steuersignal am Steuersignaleingang 4 gesteuert. Ein Low-Side-Treiber ist vorzugsweise vorgesehen, um das Gate des verwendeten Schaltelements Q1 anzusteuern. Das Schaltelement Q1 leitet nur für eine extrem begrenzte Zeit, wenn das externe Lasertriggersignal 12 mit einem positiven Pegel aktiviert wird.

Figur 6a zeigt die elektronische Schaltung 1 mit dem Eingangskontakt 3 für die Eingangsspannung, mit mindestens der mit dem Eingangskontakt verbundenen Spule L1, mit mindestens der mit der Spule L1 in Reihe geschalteten ersten Diode D1, wobei die erste Diode D1 in Durchlassrichtung für die Eingangsspannung geschaltet ist, wobei mindestens das mit der Kathode der ersten Diode D1 verbundene Schaltelement Q1 angeordnet ist.

Jedoch kann gemäß Figur 6b mit dem Eingangskontakt 3 auch die Diode D1 verbunden sein und mit der Diode D1 die Spule L1 in Reihe geschaltet sein, so dass die Spule L1 und die Diode D1 eine Reihenschaltung bilden.

Gemäß Figur 6a und 6b sind weitere Laserdioden LD jeweils parallel angeordnet. Die Laserdioden LD weisen jeweils eine antiparallele Diode D2, D3 bzw. Dn auf. Zu der jeweilen Laserdiode LD ist jeweils ein Kondensator C2, C3 bzw. Cn in Reihe geschaltet und am anderen Ende mit Masse verbunden.

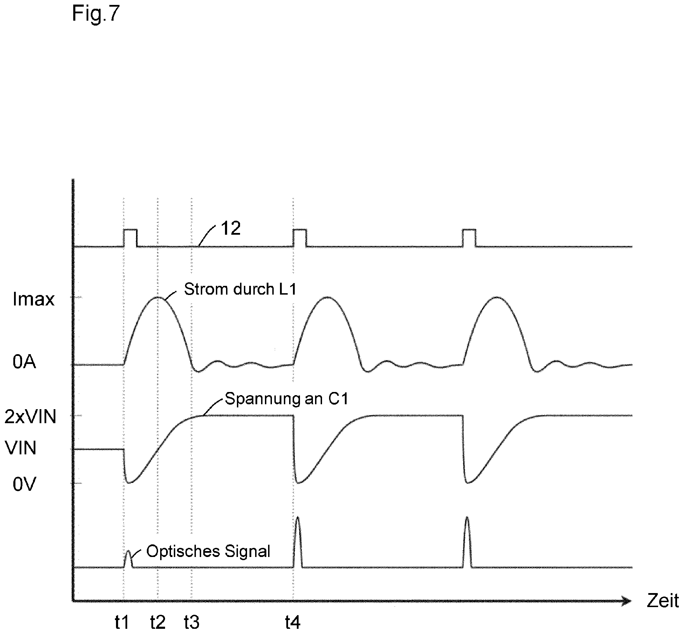

Figur 7 zeigt ein Diagramm der auftretenden Signale und Spannungen und Ströme. Das Diagramm von Figur 6 zeigt das Signal des Lasertriggersignals 12, den Strom durch die Spule L1, die Spannung am ersten Kondensator C1 und das optische Signal an der Laserdiode LD. Insbesondere sind relevante Zeitpunkte t1, t2, t3 und t4 dargestellt. Mit VIN ist die Eingangsspannung bezeichnet. Mit Imax ist ein maximaler Strom durch die Spule L1 bezeichnet.

Während des ersten Pulses von Lasertriggersignal 12, beginnend bei einem ersten Zeitpunkt t1 gemäß Figur 6, wird der erste Kondensator C1 vollständig durch die Laserdiode LD und das Schaltelement Q1 entladen und ein erster niedrigerer Laserpuls erzeugt. In diesem Moment ist der Spannungspegel der Laserdiodenkathode (entspricht dem Drainanschluss des Schaltelements Q1) der gleiche wie die Massereferenz, was zu einem Spannungsabfall vom zweiten Kondensator C2 auf das Schaltelement Q1 gleich der Eingangsspannung führt. Ein Strom durch die Spule L1 und der ersten Diode D1 beginnt zu fließen.

Nachdem das Schaltelement Q1 geschlossen wurde, steigt der Strom durch die Spule L1 und die erste Diode D1 weiter an und lädt den ersten Kondensator C1 bis zur Spannung der zweiten Diode D2, bis der Spannungspegel an der Laserdiodenkathode bei einem zweiten Zeitpunkt t2 die Höhe der Eingangsspannung erreicht und nun auf dem gleichen Spannungsniveau wie der zweite Kondensator C2 liegt. Von nun an nimmt der Strom durch die Spule L1 ab, bis er bei einem dritten Zeitpunkt t3 wieder 0 Ampere erreicht. Währenddessen wird der erste Kondensator C1 immer noch auf ein Spannungsniveau geladen, das fast dem zweifachen der Eingangsspannung entspricht.

Nach dem dritten Zeitpunkt t3 wird ein negativer Strom durch die Spule L1 durch die erste Diode D1 verhindert, so dass der erste Kondensator C1 nicht durch die Laserdiode LD und die Spule L1 entladen wird. Unter realen Bedingungen bleibt nur eine leichte Schwingung zurück, die nicht zu einer unerwünschten Beleuchtung der Laserdiode LD führt. Der erste Kondensator C1 speichert die Energie für den nächsten Laserpuls mit einer Ladespannung von fast zweimal der Eingangsspannung, bis das Lasertriggersignal 12 die Schaltung bei einem vierten Zeitpunkt t4 wieder auslöst.

Das Schaltelement Q1 wird nur für eine begrenzte Zeit, insbesondere eine extrem begrenzte Zeit, nämlich wenige Nanosekunden geschlossen, um den Laserlichtpuls freizusetzen. Während dieser Zeit kann sich kein nennenswerter Strom durch die Spule L1 und das Schaltelement Q1 aufbauen. Aber die sehr kurze Zeit, in der das Schaltelement Q1 geschlossen ist, reicht aus, dass der Spannungspegel der Laserdiodenkathode nahe 0 Volt beträgt und der zuvor beschriebene Ladestrom in Gang gesetzt wird. Solange das Schaltelement Q1 nicht viel länger geschlossen ist, beträgt die Spannung an dem ersten Kondensator C1 nach dem Laden fast das Doppelte der Eingangsspannung, unabhängig davon, wann das Schaltelement Q1 geschlossen war. Das bedeutet zum einen, dass mit der Schließzeit des Schaltelements Q1 die Möglichkeit verloren geht, die Ladespannung direkt zu steuern. Andererseits ist es nicht möglich, eine Spannung zu erzeugen, die höher als das Doppelte der Eingangsspannung ist, und somit ist die maximale Energie pro Impuls absolut vorhersagbar. Es ist kein zusätzlicher Sicherheitsmechanismus, z. B. Hochgeschwindigkeits-Spannungsmessung erforderlich. Und die Energie pro Impuls kann immer noch durch Änderung der Eingangsversorgungsspannung gesteuert werden, die mit einer relativ langsamen Spannungsmessung gemessen werden kann.

Um die Anfälligkeit gegenüber einer falschen Pulsbreite des Lasertriggersignals 12 weiter zu verbessern, kann die Spule L1 bzw. Induktivität verwendet werden, bei der der Spitzenladestrom durch die Spule L1 nahe am Sättigungsstrom des Induktortyps liegt. Selbst wenn die Pulsbreite des Lasertriggersignals 12 zu groß ist, ist die Spule L1 bzw. Induktivität nicht in der Lage, mehr magnetische Energie zu speichern und so eine Überladung des ersten Kondensators C1 zu verhindern. Außerdem steigt der Strom durch die Spule L1 schnell an und ein einfach zu implementierender Leistungsschalter kann eine solche Fehlersituation erkennen.

Bei der Laserdiode LD handelt es sich beispielsweise um eine 5J VCSEL Laserdiode oder einen mehrkanaligen Kantenemitter.

Bevorzugt ist das Schaltelement Q1 insbesondere ein Schalttransistor, insbesondere ein Feldeffekttransistor FET-Q1, ganz insbesondere ein Galliumnitrid-Feldeffekttransistor GaN-Q1.

Vorzugsweise ist das Lasertriggersignal 12 durch einen Low-Side-FET-Treiber erzeugt. Der Low-Side-FET-Treiber ist eine integrierte elektronische Schaltung, welche den Leistungsschalter also das Schaltelement Q1 ansteuert.

Ein Transistor-Treiber bzw. der Low-Side-FET-Treiber ist eine Schaltung, welche die nötige Spannung zur Verfügung stellt, um das Schaltelement Q1 in der erforderlichen Zeit ein- bzw. auszuschalten. Es handelt sich dabei meist um einen Verstärker mit zusätzlichem Pegelwandler. Dadurch ist es möglich, mit einem Logikausgang, welcher meist mit 5 oder 3,3V betrieben wird, große Lasten wie Feldeffekttransistoren FET-Q1 zu schalten. Dieser Treiber kann analog oder digital arbeiten.

Während des ersten Pulses von Lasertriggersignal 12, beginnend bei einem ersten Zeitpunkt t1, wird der erste Kondensator C1 vollständig durch die Laserdiode LD und das Schaltelement Q1 entladen und ein erster niedrigerer Laserpuls erzeugt. In diesem Moment ist der Spannungspegel der Laserdiodenkathode der gleiche wie die Massereferenz, was zu einem Spannungsabfall vom zweiten Kondensator C2 auf das Schaltelement Q1 gleich der Eingangsspannung führt. Wird die Pulsbreite des Lasertriggersignals 12 länger gewählt als die berechnete Laserpulsbreite, wird eine vollständige Entladung des erste Kondensators C1 gewährleistet.

Vorzugsweise ist die Kapazität des zweiten Kondensators C2 mindestens 500 mal größer und insbesondere 1000 mal größer, als die Kapazität des ersten Kondensators C1.

Bevorzugt wird das Schaltelement Q1 durch das Lasertriggersignal 12 nur 5 bis 30 Nanosekunden, insbesondere 15 bis 20 Nanosekunden geschlossen, um einen Laserimpuls an der Laserdiode LD freizusetzen.

Die Weiterbildung betrifft eine Treiberschaltung für Laserdioden LD in einer gepulsten Laserlichtanwendung mit einer Pulsbreite von wenigen Nanosekunden, insbesondere 5 bis 20 ns und hoher Pulsenergie, beispielsweise wenige μJ pro Laserschuss mit hohen Spitzenströmen. Beispielsweise größer 100 Ampere werden verwendet.

Bevorzugt wird die Energie pro Laserpuls durch eine Steuerung der Eingangsversorgungsspannung eingestellt.

Mittels der verwendeten Eingangsversorgungsspannung kann somit die Energie pro Laserpuls einfach eingestellt bzw. gesteuert oder geregelt werden.

Vorzugsweise bilden der erste Kondensator C1, die Laserdiode LD und das Schaltelement Q1 einen resonanten Entladungslasertreiber.

Im Gegensatz zur herkömmlichen Lösung wird die Ladeschaltung jedoch mit der Kathodenseite des Lasertreibers verbunden, während die Kapazität noch mit der Anode verbunden ist. Um einen Stromfluss zum Aufladen zu ermöglichen, wird eine antiparallele zweite Diode D2 hinzugefügt. Mit dieser Änderung wird der kritischste Ausfall eines kurzgeschlossenen Schaltelements überwunden.

Vorzugsweise bilden die Spule L1, die erste Diode D1 und das Schaltelement Q1 eine Aufwärtswandlerschaltung.

Um den vergleichbar niedrigen Wirkungsgrad von 50 % mit einem üblicherweise verwendeten Ladewiderstand zu überwinden, wird eine Schaltung mit einer gemeinsamen Aufwärtswandlertopologie, bestehend aus der Spule L1, der ersten Diode D1 und dem Schaltelement Q1 verwendet. Es wird das Hochgeschwindigkeitsschaltelement des Schwingantriebskreises verwendet, wobei dieses nur für eine begrenzte Zeit, insbesondere eine extrem begrenzte Zeit geschlossen ist, sodass schaltungsbedingt eine nur in Abhängigkeit der Eingangsspannung und damit deterministische Spannung erzeugt wird, welche nahezu der zweifachen Eingangsspannung entspricht.

Beispielhafte konkrete Werte für die Bauteile sind:

$$C2 = 2x\ 4{,}7\ uF\ (\sim 10\ uF)$$

$$L1 = 6{,}8\ \mu H$$

D1 = NEXPERIA PMEG3010 (Schottky Diode mit niedriger VF)
Q1 = EPC EPC2088 (GaN Enhancement Mode Power Transistor)
D2 = NEXPERIA PMEG3010 (Schottky Diode mit niedriger VF)
LD (Laserdiode) = AMS TORONTO (800W 940nm 5J-VCSEL)
C1 = 3x 3,9 nF Keramikkondensatoren (11,7 nF)
Eingangsspannung = 25-35 V
Gate Driver = TI LMG1020

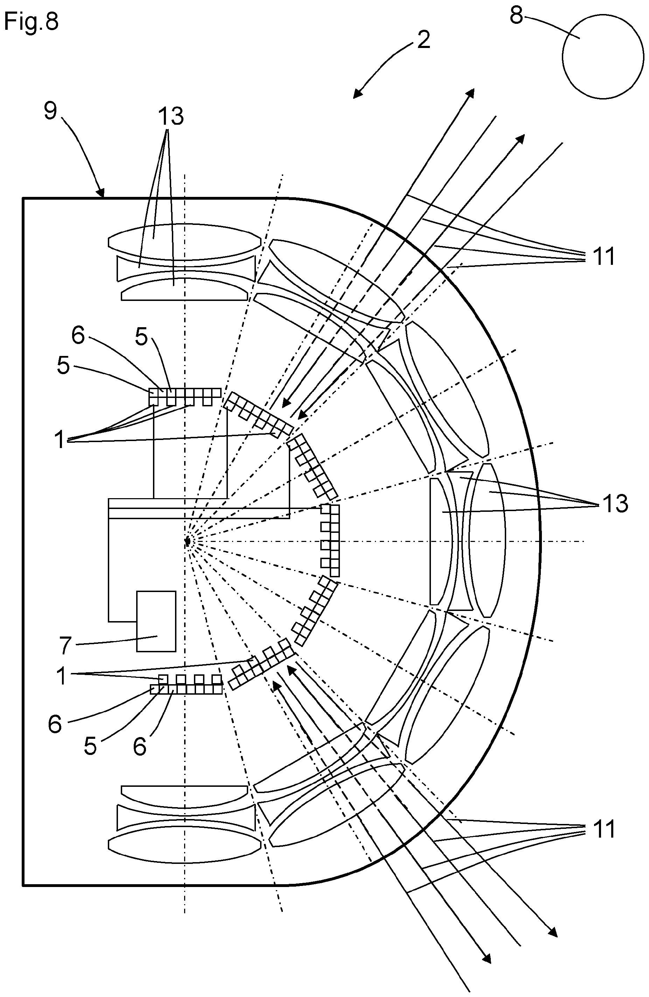

Figur 8 zeigt einen Laserscanner 2 mit elektronischen Schaltungen 1. Der Laserscanner 2 weist mindestens ein Sendeelement 5 und mindestens ein Empfangselement 6 und eine Steuer- und Auswerteeinheit 7 zur Auswertung der Lichtlaufzeit von Lichtstrahlen vom Sendeelement 5 über ein Objekt 8 zum Empfangselement 6 auf. Das Sendeelement 5 weist die Laserdiode LD auf. Vor den Sendeelementen 5 und den Empfangselementen 6 sind optionale Linsen 13 angeordnet. Zur besseren Übersichtlichkeit sind nicht alle Signalverbindungen zu den elektronischen Schaltungen 1 dargestellt.

Gemäß Figur 8 sind dabei eine Vielzahl von Sendeelementen 5 und eine Vielzahl von Empfangselementen 6 in einem gemeinsamen Gehäuse 9 angeordnet, wobei die Lichtstrahlen 11 in verschiedenen Winkelrichtungen fächerförmig ausgesendet und/oder empfangen werden, wobei sich die Abstände der ausgesendeten Lichtstrahlen der Sendeelemente 5 mit größer werdendem Abstand zum Laserscanner 2 vergrößern und/oder die Abstände der empfangenen Lichtstrahlen der Empfangselemente 6 mit kleiner werdendem Abstand zum Laserscanner 2 verkleinern. Die Sendeelemente 5 und Empfangselemente 6 sind beispielsweise in einer Reihe angeordnet. Eine Winkelablenkung kann über eine Optik erfolgen. Jedoch können die Sendeelemente 5 und Empfangselemente 6 auch kreisabschnittsförmig angeordnet sein.

Eine bevorzugte Anwendung ist der Einsatz der elektronischen Schaltung 1 in einem LiDAR-Sensor der Laserklasse 1.

Gemäß der Weiterbildung werden die Lichtstrahlen 11 in verschiedenen Winkelrichtungen fächerförmig ausgesendet bzw. empfangen, wodurch ein Überwachungsbereich dahingehend einfach untersucht werden kann, ob Objekte 8 in dem Überwachungsbereich vorhanden sind oder nicht und an welcher Stelle, d. h. in welcher Entfernung die Objekte vorhanden sind. Weiter können die Objekte 8 vermessen werden, bzw. eine Umgebungskontur und deren Veränderung erfasst werden. Durch die fächerförmige Aussendung der Lichtstrahlen, bzw. das fächerförmige Empfangen wird der Überwachungsbereich innerhalb einer fächerförmigen Ebene überwacht. Die Sendeelemente 5 bzw. Empfangselemente 6 sind beispielsweise im Umfang eines Zylinders radialsymmetrisch angeordnet. Der Laserscanner 2 kann mit einer hohen Winkelgenauigkeit hergestellt werden, da die Sendeelemente 5 und Empfangselemente 6 fest fixiert sind und die Lichtstrahlen 11 direkt, ohne bewegliche Teile in den Überwachungsbereich gelangen. Bei der Produktion des Laserscanners 2 kann die Winkelgenauigkeit der Winkelrichtungen geprüft und eingestellt werden. Dadurch ist gewährleistet, dass jeder Laserscanner 2 eine bestimmte geforderte mindeste Winkelgenauigkeit einhält.

Beispielsweise weist der Laserscanner 2 in einer alternativen Ausführung mindestens ein Sendeelement 5 und mindestens ein Empfangselement 6 und eine Steuer- und Auswerteeinheit 7 zur Auswertung der Lichtlaufzeit von Lichtstrahlen 11 vom Sendeelement 5 über ein Objekt 8 zum Empfangselement 6 auf. Dabei ist eine Umlenkeinheit vorgesehen zur Ablenkung der Sendelichtstrahlen des Sendelements 5 und/oder zur Ablenkung der Empfangslichtstrahlen für das Empfangselement 6. Das Sendeelement 5 weist die Laserdiode LD auf.

Durch die Umlenkeinheit braucht nur ein einziges Sendeelement 5 und/oder ein einziges Empfangselement 6 vorgesehen zu werden.

Beispielsweise ist der Laserscanner ein Mehrebenenlaserscanner, wobei der Mehrebenenlaserscanner ausgebildet ist mehrere Abtastebenen zu bilden. Beispielsweise können die mehreren Abtastebenen fächerförmige angeordnet sein. Es kann aber auch vorgesehen sein mehrere parallele Abtastebenen zu bilden

Bezugszeichen:

1 Elektronische Schaltung
2 Laserscanner
3 Eingangskontakt
4 Steuersignaleingang
5 Sendeelement
6 Empfangselement
7 Steuer- und Auswerteeinheit
8 Objekt
9 Gehäuse
11 Lichtstrahlen
12 Lasertriggersignal

13 Linsen
C1 erster Kondensator
L1 Spule
D1 erste Diode
Q1 Schaltelement
LD Laserdiode
D2 zweite Diode
C2 zweiter Kondensator
FET-Q1 Feldeffekttransistor
GaN-Q1 Galliumnitrid-Feldeffekttransistor

**Patentansprüche**

1.  Elektronische Schaltung (1) zur Erzeugung von Laserpulsen für einen Laserscanner (2),

    mit einem Eingangskontakt (3) für eine Eingangsspannung,
    mit einer mit dem Eingangskontakt (3) verbundenen Reihenschaltung, bestehend aus mindestens einer Spule (L1) und mindestens einer ersten Diode (D1), wobei die erste Diode (D1) in Durchlassrichtung für die Eingangsspannung geschaltet ist,
    **dadurch gekennzeichnet, dass**
    mindestens ein mit der Reihenschaltung verbundenes Schaltelement (Q1) angeordnet ist,
    wobei mittels des Schaltelements (Q1) ein Schaltpfad gebildet ist,
    wobei an dem Gate des Schaltelements (Q1) ein Lasertriggersignal (12) anlegbar ist,
    wobei mit der Kathode der ersten Diode (D1) und dem Schaltelement (Q1) mindestens eine Anti-Parallelschaltung aus einer Laserdiode (LD) und einer zweiten Diode (D2) an einem Ende verbunden ist,
    wobei die Antiparallelschaltung von der Laserdiode (LD) und der zweiten Diode (D2) an dem anderen Ende mit mindestens einem ersten Kondensator (C1) verbunden ist,
    und der erste Kondensator (C1) mit dem anderen Ende mit Masse verbunden ist,
    wobei durch das Lasertriggersignal (12) an dem Schaltelement (Q1) ein optischer Laserpuls an der Laserdiode (LD) erzeugbar ist.

2.  Elektronische Schaltung (1) nach Anspruch 1, **dadurch gekennzeichnet, dass** mindestens ein mit dem Eingangskontakt (3) verbundener parallel geschalte-ter zweiter Kondensator (C2) angeordnet ist.

3.  Elektronische Schaltung (1) nach Anspruch 1, **dadurch gekennzeichnet, dass** das Schaltelement (Q1) ein Schalttransistor, insbesondere ein Feldeffekttransistor (FET-Q1) ist, insbesondere ein Galliumnitrid-Feldeffekttransistor (GaN-Q1) ist.

4. Elektronische Schaltung (1) nach einem der vorhergehenden Ansprüche, **dadurch gekennzeichnet, dass** das Lasertriggersignal (12) durch einen Low-Side-Treiber erzeugt ist.

5. Elektronische Schaltung (1) nach Anspruch 2, **dadurch gekennzeichnet, dass** die Kapazität des zweiten Kondensators (C2) mindestens 500 mal größer und insbesondere 1000 mal größer ist, als die Kapazität des ersten Kondensators (C1).

6. Elektronische Schaltung (1) nach einem der vorhergehenden Ansprüche, **dadurch gekennzeichnet, dass** das Schaltelement (Q1) durch das Lasertriggersignal (12) nur 5 bis 50 Nanosekunden, insbesondere 15 bis 20 Nanosekunden geschlossen wird, um einen Laserimpuls an der Laserdiode (LD) freizusetzen.

7. Elektronische Schaltung (1) nach einem der der vorhergehenden Ansprüche, **dadurch gekennzeichnet, dass** die Energie pro Laserpuls durch eine Steuerung der Eingangsversorgungsspannung eingestellt wird.

8. Elektronische Schaltung (1) nach einem der der vorhergehenden Ansprüche, **dadurch gekennzeichnet, dass** eine Energie pro Laserpuls nicht durch eine Veränderung der Pulsbreite des Lasertriggersignals (12) eingestellt wird.

9. Elektronische Schaltung (1) nach einem der der vorhergehenden Ansprüche, **dadurch gekennzeichnet, dass** der erste Kondensator (C1), die Laserdiode (LD) und das Schaltelement (Q1) einen resonanten Entladungslasertreiber bilden.

10. Elektronische Schaltung (1) nach einem der der vorhergehenden Ansprüche, **dadurch gekennzeichnet, dass** die Induktivität (L1), die erste Diode (D1) und das Schaltelement (Q1) eine Aufwärtswandlerschaltung bilden, wobei das Schaltelement (Q1) nur für eine begrenzte Zeit geschlossen ist, sodass schaltungsbedingt eine nur in Abhängigkeit der Eingangsspannung und damit deterministische Spannung erzeugt wird, welche nahezu der zweifachen Eingangsspannung entspricht.

11. Elektronische Schaltung (1) nach einem der der vorhergehenden Ansprüche, **dadurch gekennzeichnet, dass** der Antiparallelschaltung von der Laserdiode (LD) und der zweiten Diode (D2) weitere Antiparallelschaltungen von Laserdioden (LD) und Dioden parallel geschaltet sind, wobei diese Antiparallelschaltungen jeweils mit mindestens einem weiteren Kondensator verbunden sind, und diese mit dem anderen Ende mit Masse verbunden ist, wobei durch das Lasertriggersignal an dem Schaltelement (Q1) ein optischer Laserpuls zeitgleich an allen Laserdioden (LD) erzeugbar ist.

12. Elektronische Schaltung (1) nach Anspruch 9, **dadurch gekennzeichnet, dass** die Laserdioden (LD) in einem gemeinsamen Gehäuse (9) oder auf einem gemeinsamen Substrat angeordnet sind.

13. Laserscanner (2) mit mindestens einem Sendeelement (5) und mindestens einem Empfangselement (6) und einer Steuer- und Auswerteeinheit (7) zur Auswertung der Lichtlaufzeit von Lichtstrahlen vom Sendeelement (5) über ein Objekt (8) zum Empfangselement (6) mit einer elektronischen Schaltung (1) gemäß einem der Ansprüche 1 bis 9.

14. Laserscanner (2) nach Anspruch 13, **dadurch gekennzeichnet, dass** eine Vielzahl von Sendeelementen (5) und eine Vielzahl von Empfangselementen (6) in einem gemeinsamen Gehäuse (9) angeordnet sind, wobei die Lichtstrahlen (11) in verschiedenen Winkelrichtungen fächerförmig ausgesendet und/oder empfangen werden, wobei sich die Abstände der ausgesendeten Lichtstrahlen (11) der Sendeelemente (5) mit größer werdendem Abstand zum Laserscanner (2) vergrößern und/oder die Abstände der empfangenen Lichtstrahlen (11) der Empfangselemente (6) mit kleiner werdendem Abstand zum Laserscanner (2) verkleinern.

15. Laserscanner (2) nach Anspruch 13, **dadurch gekennzeichnet, dass** eine Umlenkeinheit vorgesehen ist zur Ablenkung der Sendelichtstrahlen des Sendelements (5) und/oder zur Ablenkung der Empfangslichtstrahlen für das Empfangselement (6).

16. Laserscanner (2) nach Anspruch 13, **dadurch gekennzeichnet, dass** der Laserscanner (2) ein Mehrebenenlaserscanner ist, wobei der Mehrebenenlaserscanner ausgebildet ist mehrere Abtastebenen zu bilden.

# Fig.1 (Stand der Technik)

IC1

VIN
~ 30V

<10 mΩ

C1
~100 nF

VCSEL

Laser_Trigger

# Fig.2 (Stand der Technik)

~ 100 Ω

VIN
~ 60V

R2

C1
~10 nF

Parasitic
Loop
Inductance

VCSEL

Q1

GaN-FET

Laser_Trigger

Gate
Driver

# Fig.3 (Stand der Technik)

# Fig.4 (Stand der Technik)

Fig.5

Fig.5a

Fig.6

Fig.6a

1

Fig.6b

Fig.7

Imax — Strom durch L1

0A

2xVIN — Spannung an C1
VIN
0V

Optisches Signal

Zeit

t1  t2  t3        t4

Fig.8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9368936 B
- US 11075502 B2
- US 11631961 B2
- US 10673204 B2
- US 20210333362 A1